# EUROPEAN PATENT SPECIFICATION

(11) **EP 3 289 369 B1**
(45) Date of publication and mention of the grant of the patent: **26.06.2024**
(21) Application number: 16762319.8
(22) Date of filing: 07.03.2016
(51) Int. Cl.: G01R 27/26, H03M 3/00

(54) **WIDEBAND CAPACITIVE SENSING USING SENSE SIGNAL MODULATION**
BREITBANDIGE KAPAZITIVE MESSUNG ANHAND VON MESSSIGNALMODULATION
DÉTECTION CAPACITIVE DE LARGE BANDE À L'AIDE D'UNE MODULATION DE SIGNAL DE DÉTECTION

(30) Priority: 06.03.2015 US 201562129694 P
(43) Date of publication of application: 07.03.2018
(73) Proprietor: Texas Instruments Incorporated, Dallas, TX 75265-5474 (US)
(72) Inventor: REITMSA, George P., Redwood City, CA 94061 (US); SILVA, Paulo Gustavo Raymundo, Sunnyvale, CA 94086 (US); BAPAT, Sumant, San Jose, CA 95138 (US); HENDERSON, Richard D., San Jose, CA 95136 (US)
(74) Representative: Zeller, Andreas
(86) International application number: PCT/US2016/021259
(87) International publication number: WO 2016/144911

(56) References cited:
- EP-A2- 2 100 783
- EP-A2- 2 172 834
- US-A1- 2007 109 274
- US-A1- 2008 180 278
- US-A1- 2012 217 981
- US-A1- 2013 271 434
- US-A1- 2014 049 266
- US-A1- 2014 049 266
- US-A1- 2014 077 823
- US-B1- 8 766 950
- US-B1- 8 766 950

## Description

This relates generally to capacitive sensing.

### BACKGROUND

For capacitive sensing, capacitance variations in a sense capacitor can be measured by measuring the charge storage capacity of the sensing capacitor. Such charge transfer approaches use a two phase charge transfer cycle (or four phase if differential): (a) an excitation/charge phase in which a sense capacitor is charged to a well-defined reference voltage, and (b) an acquisition/transfer phase in which charge is removed and accurately measured.

A problem for capacitive sensing systems is susceptibility to electromagnetic interference (EMI), such as from radio frequency sources. Increasing sensing range generally requires increasing sensor capacitance size, which increases susceptibility to EMI. Particularly in the case of capacitive sensing based on charge transfer, sampling the charge on the sensor capacitor will also sample EMI, increasing sensitivity to EMI due to aliasing. US 2008/180278 relates to a chopper-stabilized instrumentation amplifier for wireless telemetry. US 2007/109274 relates to methods and systems for detecting a position-based attribute of an object using digital codes.

### SUMMARY

A circuit and a method for capacitive sensing are provided by respective claims 1 and 9. Described examples include apparatus and methods for wideband capacitive sensing using sense (capacitance) signal modulation, which can be adapted for single ended or differential capacitive sensing.

According to aspects, wideband capacitive sensing can include: (a) generating a carrier signal at a carrier frequency (such as fixed frequency or spread spectrum); (b) generating a reference signal; (c) in a carrier/drive signal path, generating a carrier/drive signal for output to the at least one sense capacitor, including modulating the reference signal with the carrier signal to generate the carrier/drive signal at the carrier frequency, and driving the carrier/drive signal out to the at least one sense capacitor to generate at least one up-modulated sense capacitance signal, corresponding to measured capacitance and up-modulated to the carrier frequency; and (d) in a sense signal path, receiving the sense capacitance signal corresponding to measured capacitance from the at least one sense capacitor, the sense capacitance signal up-modulated to the carrier frequency by the carrier/drive signal, and amplifying the up-modulated sense capacitance signal, and demodulating the amplified up-modulated sense capacitance signal using the carrier signal, generating a demodulated sense capacitance signal. The demodulated sense capacitance signal can be converted to sensor data corresponding to the sense capacitance signal from the at least one sense capacitor (such as by a sigma delta converter that includes input Nyquist filtering and carrier image rejection, the sigma delta converter referenced by the reference signal). Differential wideband capacitive sensing can include: (a) in the carrier/drive signal path, generating first and second carrier/drive signals, driven out respectively to the first and second sense capacitors; (b) wherein, in response to the first and second carrier drive signals, the first and second sense capacitors provide respective first and second up-modulated sense capacitance signals, corresponding to measured capacitance and up-modulated to the carrier frequency; and (c) in the sense signal path, summing the first and second up-modulated sense capacitance signals as an up-modulated differential sense capacitance signal.

According to other aspects, wideband capacitive sensing can include: (a) in the carrier/drive signal path, pre-scaling the carrier/drive signal; (b) in the sense signal path, EMI filtering the up-modulated sense capacitance signal before amplification, and/or bandpass filtering the up-modulated sense capacitance signal before amplification; (c) in the sense signal path, accomplishing amplification by one of a charge amplifier including a feedback capacitor coupled to the amplifier inverting input, which is coupled to receive the up-modulated sense capacitance signal, and a transimpedance amplifier including a feedback resistor coupled to the amplifier inverting input, which is coupled to receive the up-modulated sense capacitance signal, with the carrier/drive signal path further including integrating the carrier/drive signal.

### BRIEF DESCRIPTION OF THE DRAWINGS

FIGS. 1A and 1B illustrate an example embodiment of wideband capacitive sensing architecture with sense (capacitance) signal modulation.
FIG. 2 illustrates an example alternate embodiment of a WCDC.
FIG. 3 illustrates an example alternate embodiment of a WCDC.
FIG. 4 illustrates differential wideband capacitive sensing with a fixed sensing modulation/demodulation carrier.
FIG. 5 illustrates differential wideband capacitive sensing in which post-demodulation filtering and data conversion are integrated as a sigma delta converter.
FIG. 6 illustrates differential wideband capacitive sensing with a spread spectrum carri er.

### DETAILED DESCRIPTION OF EXAMPLE EMBODIMENTS

In brief overview, wideband capacitive sensing based on a modulated sense (capacitance) signal is adaptable for single-ended or differential sensing applications. A wideband capacitive sensing architecture can be implemented with a wideband capacitance-to-data converter (WCDC) coupled to single or differential sense capacitor(s). The WCDC can be implemented with a carrier/drive signal path to generate and drive out a carrier/drive signal modulated to a carrier frequency, and a sense signal path to receive an up-modulated sense capacitance signal corresponding to measured capacitance from capacitive sensing, up-modulated to the carrier frequency, and to generate a demodulated sense capacitance signal to capture the measured capacitance. The carrier/drive signal path modulates a reference signal with a carrier signal (such as fixed frequency or spread spectrum) to generate the carrier/drive signal, which is driven (with optional pre-scaling) out through an output node (to single or dual sense capacitors). The sense signal path receives at an input/summing node up-modulated sense capacitance signal(s), corresponding to measured capacitance up-modulated to the carrier frequency, and, after filtering (optional) and amplification, demodulates the up-modulated sense capacitance signal with the carrier signal, to generate a demodulated sense capacitance signal corresponding to measured capacitance, which can be converted to sensor data. Sense signal path amplification can use charge amplification (capacitor feedback), or transimpedance amplification (resistor feedback), including for the latter implementation, an integrator in the carrier/drive signal path. For differential capacitive sensing, differential carrier/drive signals are driven to differential sense capacitors, and the resulting up-modulated sense capacitance signals are summed at the input/summing node.

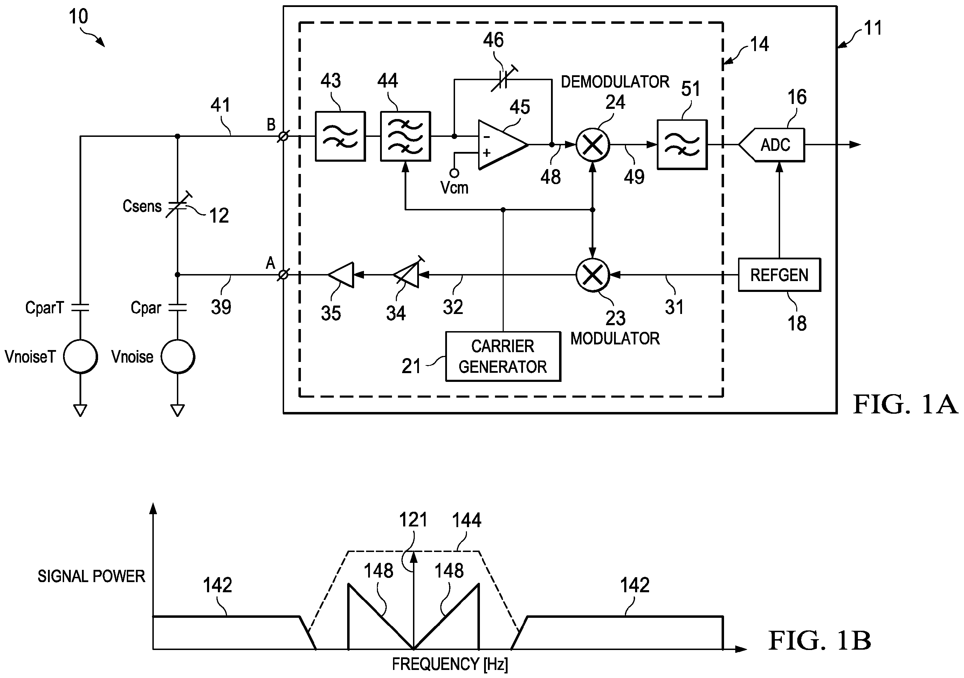

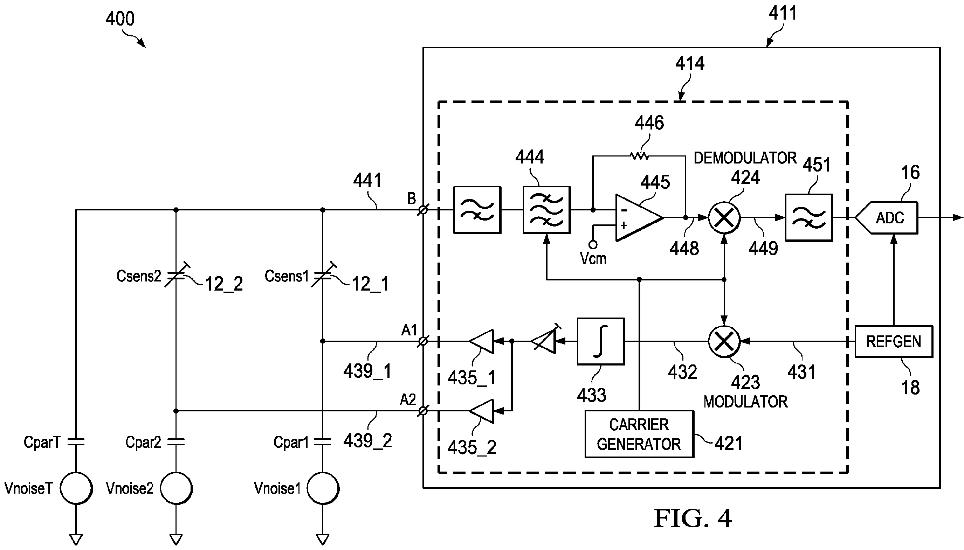

FIGS. 1A, 1B, 2 and 3 illustrate example embodiments of the wideband capacitive sensing architecture implementing wideband capacitive sensing according to example embodiments, adapted for single-ended capacitive sensing with a single sense capacitor Csens. FIGS. 4, 5 and 6 illustrate example embodiments of the wideband capacitive sensing architecture implementing wideband capacitive sensing according to example embodiments, adapted for differential capacitance sensing with dual sense capacitors Csens1/Csens2, respectively driven by in-phase and anti-phase carrier/drive signals.

For these example embodiments, in addition to the architectural choice of a single-ended or differential design, and in addition to design choices for carrier signal generation (fixed frequency or spread spectrum) and data conversion (such as analog-to-digital data conversion), a design choice in the CTCV sense signal path is implementing current-to-voltage amplification. For the FIGS. 1A, 2 and 3 example embodiments, the implementation choice is charge amplification (with capacitor feedback). For the FIG. 4, 5 and 6 example embodiments, the implementation choice is transimpedance amplification (with resistor feedback). Design considerations for choosing the CTCV sense signal path amplifier include sensing range considerations that affect the size of the sense capacitor(s), and die_area/cost considerations based on the significantly larger die area required for (feedback) capacitors compared to resistors.

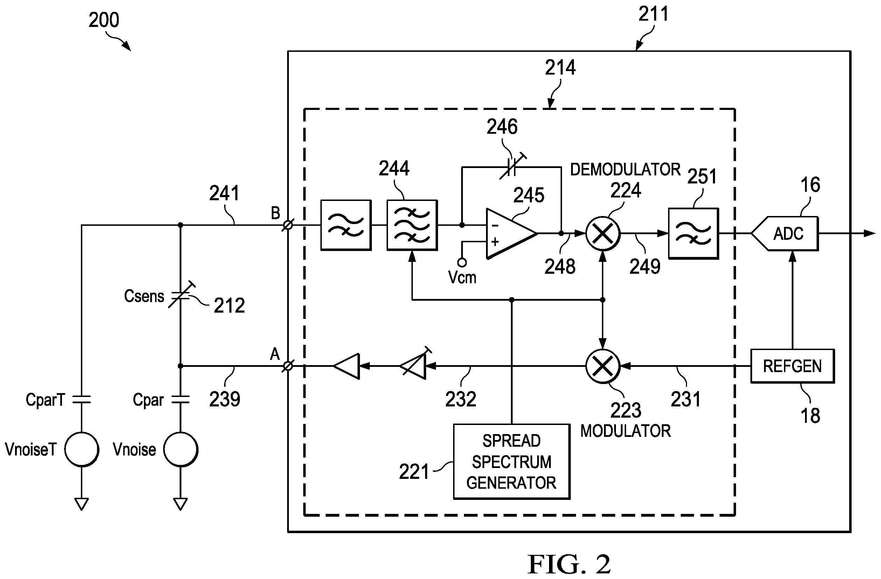

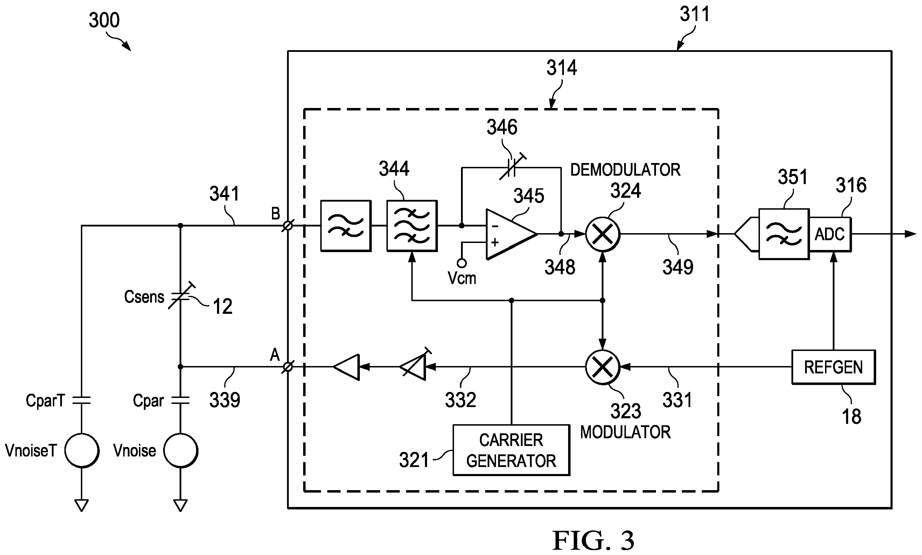

FIGS. 1A and 1B illustrate wideband single-ended capacitive sensing with a fixed carrier signal; FIG. 2 illustrates wideband single-ended capacitive sensing with a spread spectrum carrier signal; FIG. 3 illustrates wideband single-ended capacitive sensing in which post-demodulation filtering and data conversion are integrated as a sigma delta modulator/converter.

FIGS. 1A and 1B illustrate an example embodiment of wideband capacitive sensing architecture 10 with sense (capacitance) signal modulation according to example embodiments (i.e., up-modulation of the sense signal to a carrier frequency). The example wideband capacitive sensing architecture 10 is implemented with a wideband capacitance-to-data converter (WCDC) 11 interfaced to a single sense capacitor Csens 12, the WCDC including a single-ended continuous-time capacitance-to-voltage (CTCV) front end 14, and an ADC 16, the CTCV front end including a carrier generator 21 used to generate a modulated 23 carrier/drive signal, driven out (node A) to Csens, to up-modulate a sense (capacitance) signal, and to demodulate 24 the up-modulated sense signal after bandpass filtering 44 and amplification 45.

WCDC 11 includes a single-ended continuous-time capacitance-to-voltage (CTCV) front end 14 to capture sense capacitance measurements, and a data converter implemented as an analog-to-digital converter (ADC) 16 to convert the sense capacitance measurements to digital data.

CTCV front end 14 interfaces to sense capacitor Csens (12) through a carrier/drive output node A (bottom plate), and a sense signal input node B (top plate). As illustrated, at output node A, parasitic capacitance and noise sources are represented by capacitance Cpar and noise source Vnoise, and at input node B, parasitic capacitance and noise source are represented by capacitance CparT and noise source VnoiseT.

CTCV front end 14 includes a carrier/drive signal path, and a sense signal path. CTCV front end 12 uses carrier signal modulation in the carrier/drive signal path, and carrier signal demodulation in the sense signal path. In this example embodiment carrier signal modulation/demodulation is implemented with a fixed frequency carrier signal generator 21, driving a carrier signal modulator 23 in the carrier/drive signal path to provide the carrier/drive signal to the sense capacitor Csens to up-modulate sensor capacitance to the carrier frequency, and a sense signal demodulator 24 in the sense signal path to demodulate the sense capacitance signal from the carrier signal.

WCDC 11 includes a reference generator Refgen 18 that provides a reference (voltage or current) to CTCV front end 14 (carrier/drive signal path) and to ADC 16. By using the same reference generator for generating the carrier and the reference to the ADC, the absolute value of the reference does not affect sensing operation. The conversion results of the ADC correspond to input signal divided by the ADC reference (which corresponds to the full scale input of the ADC).

The CTCV carrier/drive signal path includes, in addition to modulator 23, an optional pre-scaler 34 and a (low impedance) buffer amplifier (driver) 35. Refgen 18 provides a reference signal 31, which is fed to modulator 23 driven by carrier generator 21, generating a carrier/drive signal 32. The carrier frequency can be chosen to maximize separation in frequency domain from any known interferer.

Pre-scaler 34 is useful to relax the dynamic range of the ADC. Specifically, the pre-scaler is useful to set the conversion gain of the CTCV. For example, to support a range of sense capacitors, an objective might be to optimize the signal feeding into the ADC for each sense capacitor, without saturating the ADC. For example, for a maximum sensor capacitance of 1 pF, a pre-scaler value can be selected such that an input capacitance of 1pF results in an input to the ADC that is close to its full scale input. However, if the maximum sense capacitance is 10pF, then the prescaler can be reduced by 10x, such that 10pF corresponds to almost full ADC scale.

Carrier signal 32 (optionally pre-scaled) is amplified by buffer amplifier/driver 35, providing a carrier/drive signal 39 through output node A to sense capacitor Csens. Sense capacitor Csens is driven by carrier signal 32, which up-modulates sense capacitance on Csens (measured capacitance variations) to the carrier frequency, providing an up-modulated sense signal 41 input to the CTCV sense signal path through input node B.

FIG. 1B is an example representation of the spectrum as received by the CTCV sense signal path, including a sense signal 148 up-modulated to a carrier frequency 121. In the CTCV signal path, bandpass filtering 144 is used to reject noise and EMI 142.

Referring to FIG. 1A, the CTCV sense signal path receives the up-modulated sense capacitance signal 41 through input node B. Input filtering, such as EMI filtering 43 and/or bandpass filtering 44, can be included to reject EMI and other out-of-band noise. The CTCV sense signal path includes a charge amplifier 45 (with feedback resistor 46), providing an amplified up-modulated sense capacitance signal 48 to demodulator 24 to recover the measured sense capacitance.

Amplifier 45, with feedback control 46, maintains input node B as a virtual ground, which suppresses parasitic capacitance CparT. EMI and/or bandpass filtering 43/44 can also be used, although the WCDC architecture according to example embodiments provides substantial EMI immunity, such as due to up-modulation of the sense signal, and elimination of input sampling.

After optional filtering, the up-modulated sense signal is provided to the inverting input to charge amplifier 45. Charge amplifier 45 includes capacitance feedback with a capacitor 46, providing input current integration. Accordingly, charge amplifier 25 is coupled at an inverting input to a capacitor network formed by sense capacitor Csens, and feedback capacitor 46.

The amplified up-modulated sense signal 48 is input to demodulator 24 driven by carrier generator 21. The measured sense capacitance signal (FIG. 1B, 148) is demodulated from the carrier signal (FIG. 1B, 121), and provides an analog (measured) sense capacitance signal 49.

The demodulated sense capacitance signal 49 is input to ADC 16 for conversion to digital data as a sensor capacitance measurement.

For this embodiment, data conversion is performed with an ADC. The post-demodulation sense capacitance signal 49 is filtered 51 to keep noise below the Nyquist frequency, and eliminate carrier demodulation images. The demodulated sense signal is digitized by ADC 16 to generate the sensor capacitance data provided by WCDC 11.

Because the same carrier signal 21 is used for modulation and demodulation, driving both modulator 23 in the CTCV carrier/drive signal path and demodulator 224 in the CTCV sense signal path, and because amplification is provided by a charge amplifier with capacitor feedback, the demodulated sense signal 49 input to ADC 16 is proportional to: (a) the ratio of sense capacitor Csens and feedback capacitor 46 (i.e., the capacitor input network of charge amplifier 25), and (b) the reference generated by Refgen 18 and supplied both to modulator 23 to generate the carrier/drive signal used to generate the up-modulated sense signal, and to the ADC to convert the demodulated sense (capacitance) signal to digital sensor data.

Input node B is a virtual ground node (with voltage on the input node kept substantially constant by the amplifier feedback control), substantially eliminating the impact of parasitic capacitance CparT at the input node B. Output node A is driven (with a low impedance buffer driver 44), substantially eliminating the impact of parasitic capacitance Cpar. Accordingly, the up-modulated sense capacitance across Csens is substantially unaffected by either Cpar or CparT.

Nyquist and image rejection filtering 51 are useful to suppress image band from demodulating the sense capacitance signal, increasing SNR at the output of ADC 16.

ADC topology is a design choice, such as flash, sigma delta or SAR.

Additional design tradeoffs are the use of adjustable/programmable components, including in the CTCV carrier/drive signal path, pre-scaler 34, and in the CTCV sense signal path, the feedback capacitor 46.

FIG. 2 illustrates an example alternate embodiment of a WCDC 211 including CVCT 214 in which a spread spectrum signal generator 221 is used to drive the CTCV carrier/drive path modulator 223, and the CTCV sense signal path demodulator 224. Except for the design change to using a spread spectrum carrier, the example configuration for the embodiment of FIG. 2 is the same the embodiment of FIG. 1A, including the use in the CTCV sense signal path of a charge amplifier (with capacitor feedback) 245, and the use of an ADC 16 (with an input filter 251) for conversion to digital sensor data.

Similar to the embodiment in FIG. 1A, reference signal 231 from Refgen 18 (voltage or current) is input to modulator 223 driven by the spread spectrum carrier signal 221, generating a carrier/drive signal 232, that, with optional pre-scaling 234, is driven 235 out of output node A. Carrier/drive signal 239 drives sense capacitor Csens, up-modulating the capacitance on Csens to the carrier frequency. Up-modulated sense capacitance signal 241 is coupled into the CTCV sense signal path through input node B. The up-modulated sense signal 241 can be EMI and/or bandpass filtered 243 and 244, and is then amplified by charge amplifier 245, and the amplified sense signal 248 is demodulated by demodulator 224 driven by the spread spectrum carrier 221. The demodulated sense signal 248 is filtered 251, and input to ADC 16 (referenced by Refgen 18), for conversion to digital sensor data corresponding to the measured sense capacitance signal.

This embodiment is advantageous for applications in which the carrier generator may cause interference to nearby electronics, such as when the capacitive sensor has large physical dimensions. Emission in any frequency band can be reduced using a spread spectrum carrier 221, spreading carrier emission over a wider frequency band, such that the signal power at any particular frequency in that band is reduced. Because the same spread spectrum carrier signal is used to de-modulate the amplified sense signal 248, it has no impact on the measurement accuracy. However, if bandpass filtering is used, the bandpass filter should be configured to accommodate for the wider frequency band used by the spread spectrum carrier 221.

FIG. 3 illustrates an example alternate embodiment of a WCDC 311 in which data conversion ADC is implemented as a sigma delta converter 316 that integrates post-demodulation filtering (Nyquist and image rejection) 351 for suppressing Nyquist noise and carrier demodulation images. Except for the design change to using a sigma delta converter, the example configuration for the embodiment of FIG. 3 is the same the embodiment of FIG. 1A, including the use of a fixed frequency carrier 321, and the use in the CTCV signal path of a charge amplifier 354 (with capacitor feedback 346).

Similar to FIG. 1A, the reference signal 331 from Refgen 18 (voltage or current) is input to modulator 323 driven by the carrier (fixed frequency) signal 321, generating a carrier/drive signal 332 that, with optional pre-scaling 334, is driven 335 out through CTCV output node A. Carrier/drive signal 339 drives sense capacitor Csens, up-modulating the capacitance on Csens to the carrier frequency. Up-modulated sense capacitance signal 341 is coupled into the CTCV sense signal path through input node B. The up-modulated sense signal 341 can be EMI and/or bandpass filtered 343/344, and then is amplified by charge amplifier 345, and the amplified sense signal 348 is input to demodulator 324 driven by the carrier (fixed frequency) 321. The demodulated sense signal 348 is input to sigma delta converter 316 (referenced by Refgen 18), for conversion to digital sensor data corresponding to the measured sense capacitance signal.

Lower noise is the advantage of sigma delta conversion, which integrates Nyquist and image rejection filtering 351 as part of the data converter, because noise in the first gain stage of the sigma delta converter 316 is reduced by the filter.

FIGS. 4, 5 and 6 illustrate example embodiments of the wideband capacitive sensing architecture implementing wideband capacitance sensing according to example embodiments adapted for differential capacitance sensing with dual sense capacitors Csens1/Csens2.

FIG. 4 illustrates an example embodiment of a WCDC 411 configured for wideband differential capacitance sensing with dual sense capacitors Csens1 and Csens2, the WCDC including a CTCV front end 414 including carrier (fixed frequency) generator 421 to generate modulated 423 differential carrier/drive signals 435_1 and 435_2, driven out (nodes A1 and A2) to Csens1/Csens2, to up-modulate the sense (capacitance) signals input to the CTCV front end through a summing node B, and to demodulate 424 the sense signal from the carrier signal after bandpass filtering 444 and amplification 445

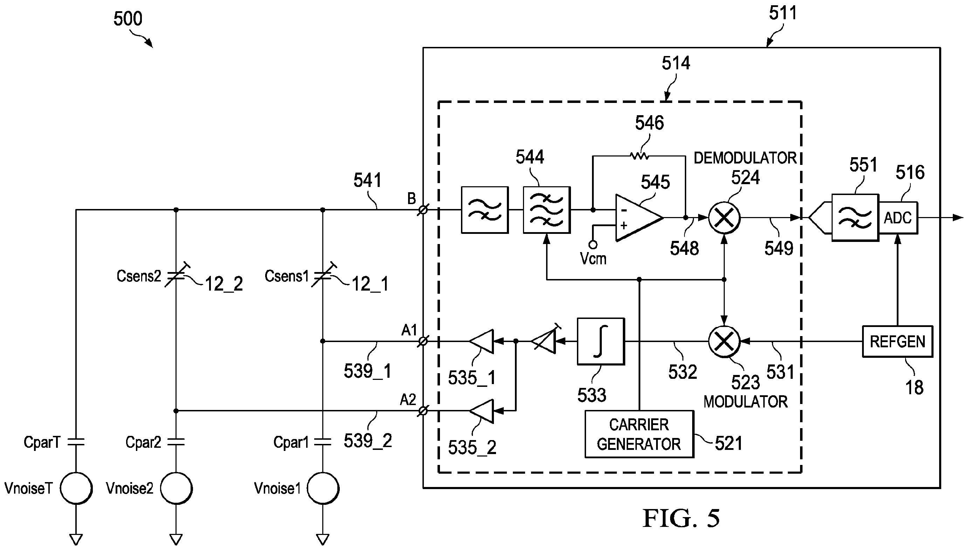

FIG. 5 illustrates an example alternate embodiment of a WCDC 511 (with differential Csens1/Csens2 sense signal input) in which the data conversion ADC is implemented as a sigma delta converter 516 that integrates post-demodulation filtering 551 for suppressing Nyquist noise and carrier demodulation images.

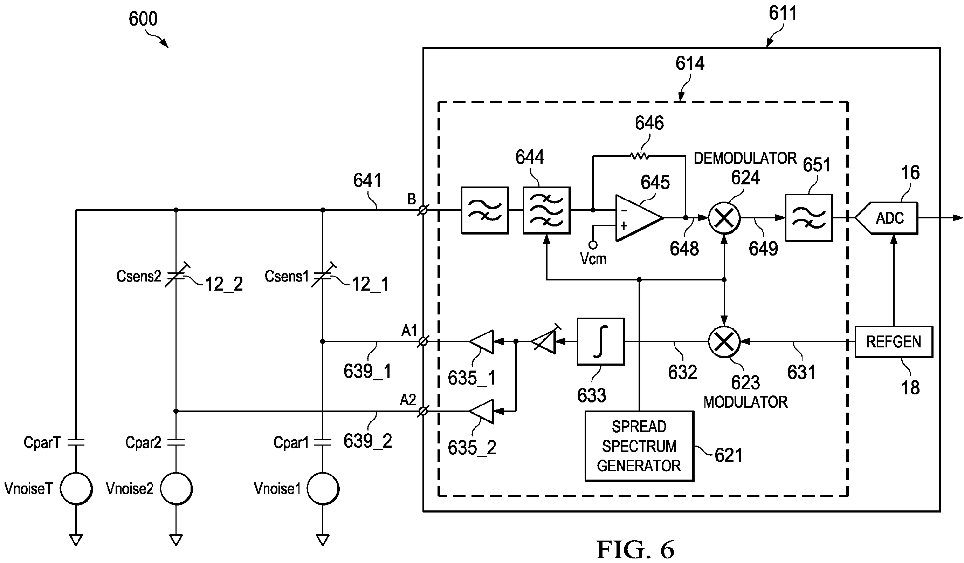

FIG. 6 illustrates an example alternate embodiment of a WCDC 611 (with differential Csens1/Csens2 capacitance sense signal input) in which a spread spectrum carrier signal 621 drives the CTCV carrier/drive signal path modulator 623, and the CTCV sense signal path demodulator 624.

For these example embodiments, in addition to using a differential capacitive sensing architecture, including generating and driving out differential carrier/drive signals to differential sense capacitors Csens1/Csens2, the CTCV sense signal path is implemented with a transimpedance amplifier (rather than the charge amplifier used in the embodiments of FIGS. 1A, 2 and 3). As in the example embodiments in FIGS. 1, 2 and 3, additional design choices include carrier signal generation (fixed frequency or spread spectrum) and data conversion (such as an ADC).

For differential capacitive sensing, the WCDC outputs sensor capacitance data (after conversion to digital) corresponding to the difference Csens1-Csens2. The CTCV carrier/drive signal path generates in-phase and anti-phase carrier/drive signals, output from respective nodes A1/A2. The differential carrier/drive signals are applied to respective sense capacitors Csens1/Csens2, in each case up-modulating the sensed capacitance to the carrier frequency.

The up-modulated sense signals are input to summing node B, and demodulated in the CTCV sense signal path, after (optional) filtering and amplification (transimpedance amplifier with feedback resistor). Because any differential change in measured capacitance results in up-modulation of the differentially sensed capacitance to the carrier frequency, the differential sense capacitance signal (summed at summing node B) is concentrated in a narrow band around the carrier.

FIG. 4 illustrates an example embodiment of differential wideband capacitive sensing architecture 410, with sense (capacitance) signal modulation according to example embodiments. The example wideband capacitive sensing architecture 410 is implemented with a differential WCDC 411 interfaced to dual sense capacitors Csens1 and Csens2 (12_1 and 12_2), for differential capacitance sensing (Csens1-Csens2).

WCDC 11 includes a CTCV front end 414 to differentially drive dual sense capacitors Csens1/Csens2 (up-modulating sensor capacitance to the carrier frequency), and to capture differential sensor capacitance measurements through input summing node B, and perform filtering (optional) amplification and demodulation to recover sense capacitance measurements. Data conversion is provided by an ADC 16 to convert the demodulated sense capacitance measurements to digital sensor data.

In the CTCV carrier/drive signal path, the reference signal 431 from Refgen 18 (voltage or current) is input to modulator 423 driven by the carrier (fixed frequency) signal 421, generating a carrier/drive signal 432. For this embodiment, with a transimpedance amplifier in the CTCV sense signal path, an integrator 433 is included in the CTCV carrier/drive signal path. The integrated carrier/drive signal 432 (with optional pre-scaling 434) is differentially driven with low impedance buffer amplifiers 435_1 and 435_2, through output nodes A1/A2 as in-phase and anti-phase carrier/drive signals 439_1 and 439_2.

The differential carrier/drive signals 439_1 and 439_2 supplied to differential sense capacitors Csens1/Csens2, up-modulating the sense capacitance to the carrier frequency.

In the CTCV sense signal path, the differential sense capacitance signals are summed at input summing node B, maintained as a virtual ground by amplifier (transimpedance) feedback control. The input differential sense capacitance measurement 441 (up-modulated to the carrier frequency) can be EMI and/or bandpass filtered 443/444, and then is amplified by a transimpedence amplifier 445/446, and demodulated by demodulator 424 driven by the carrier 421. The demodulated sense signal 448 is filtered 451, and input to ADC 16 (referenced by Refgen 18), for conversion to digital sensor data corresponding to the measured sense capacitance signal 441.

FIG. 5 illustrates an example alternate embodiment of a differential WCDC 511 in which data conversion is implemented as a sigma delta converter 516 that integrates post-demodulation filtering (Nyquist and image rejection) 551. Except for the design change to using a sigma delta converter, the example configuration for the embodiment of FIG. 5 is the same as the embodiment of FIG. 4, including the use of a fixed frequency carrier 521, and the use in the CTCV sense signal path of a transimpedance amplifier 545 (with resistor feedback 546, and with an integrator 533 in the CTCV carrier/drive signal path).

In the CTCV carrier/drive signal path, the reference signal 531 from Refgen 18 (voltage or current) is input to modulator 523 driven by the carrier (fixed frequency) signal 521, generating a carrier/drive signal 532 that is integrated 533, and then differentially driven 535_1/535_2 (with optional pre-scaling 534) through output nodes A1/A2, as in-phase and anti-phase carrier/drive signals 539_1/539_2.

The differential carrier/drive signals 539_1/539_2 are supplied to differential sense capacitors Csens1/Csens2, up-modulating sense capacitance to the carrier frequency.

Differential up-modulated sense capacitance signals are coupled into the CTCV sense signal path 514 through input summing node B, as an up-modulated (differential) sense capacitance signal 541. The input (differential) sense capacitance measurement 541 (up-modulated to the carrier frequency) can be EMI and/or bandpass filtered 543/544, and then is amplified by transimpedence amplifier 545/546, and demodulated by demodulator 524 driven by the carrier 521.

The demodulated sense signal 548 is input to sigma delta converter 516 (which integrates Nyquist and image rejection filtering 551, and is referenced by Refgen 18), for conversion to digital sensor data corresponding to the measured differential sense capacitance signal.

FIG. 6 illustrates an example alternate embodiment of a WCDC 611 in which a spread spectrum signal generator 621 is used to drive the CTCV carrier/drive path modulator 623, and the CTCV sense signal path demodulator 624, reducing emissions at a particular frequency. Except for the design change to using a spread spectrum carrier, the example configuration for the embodiment of FIG. 6 is the same the embodiment of FIG. 4, including the use in the CTCV signal path of a transimpedance amplifier 645 (with resistor feedback 646), and the use of an ADC 16 for conversion to digital sensor data.

In the CTCV carrier/drive signal path, the reference signal 631 from Refgen 18 (voltage or current) is input to modulator 623 driven by the spread spectrum signal 621, generating a carrier/drive signal 632 that is integrated 633, and then differentially driven 635_1/635_2 (with optional pre-scaling 634) through output nodes A1/A2, as in-phase and anti-phase carrier/drive signals 639_1/639_2.

The differential carrier/drive signals 639_1/639_2 supplied to differential sense capacitors Csens1/Csens2 up-modulate the sense capacitance to the carrier frequency.

Differential up-modulated sense capacitance signals are coupled into the CTCV sense signal path 614 through input summing node B, as an up-modulated (differential) sense capacitance signal 641. The input differential sense capacitance measurement 641 (up-modulated to the carrier frequency) can be EMI and/or bandpass filtered 643/644, and then is amplified by transimpedence amplifier 645/646, and demodulated by demodulator 624 driven by the spread spectrum carrier 621. If bandpass filtering is used, the bandpass filter 644 should be configured to accommodate for the wider frequency band used by the spread spectrum carrier 621.

The demodulated sense signal 648 is filtered 651, and input to ADC 16 (referenced by Refgen 18), for conversion to digital sensor data corresponding to the measured sense capacitance signal.

Configuring a wideband capacitive sensing architecture according to example embodiments for single-ended or differential capacitive sensing is a design choice. Other design choices, involving various well-known design trade-offs, for the various example embodiments include: (a) the type of up-modulating carrier signal (such as fixed frequency or spread spectrum) used to drive the sense capacitors; and (b) the data conversion approach (such as an ADC preceded by an input Nyquist/image rejection filter, or a sigma delta converter with integrated Nyquist/image rejection filtering).

Advantages of the wideband capacitive sensing architecture include noise immunity and lower power. Noise immunity results because no sampling is applied to the sensing capacitor, so no aliasing can occur, and because a carrier is used, so the information signal can be moved to a band with least interference, while all other frequencies can be suppressed. Power is reduced in the presence of large parasitic capacitors. For precision, an oversampled data converter can be advantageous for sensing applications because, due to parasitic capacitance to ground on either side of the sensing capacitor, a carrier can be chosen with a frequency just above the maximum frequency of interest, minimizing the number of harmonics, while still enabling use of an accurate oversampled sigma delta converter.

In summary, wideband capacitive sensing using sense (capacitance) signal modulation according to example embodiments can be implemented with: (a) carrier generation circuitry to generate a carrier signal at a carrier frequency (such as fixed frequency or spread spectrum); (b) reference circuitry to generate a reference signal; (c) carrier/drive signal path circuitry to drive a carrier/drive signal out through an output node, the carrier/drive signal useable for capacitive sensing, and including modulation circuitry to modulate the reference signal with the carrier signal to generate the carrier/drive signal at the carrier frequency, and drive circuitry to drive the carrier/drive signal out through the output node; and (d) sense signal path circuitry to receive at an input node an up-modulated sense capacitance signal corresponding to measured capacitance from capacitive sensing, wherein the sense capacitance signal is up-modulated to the carrier frequency based on the carrier/drive signal, including amplifier circuitry to generate an amplified up-modulated sense capacitance signal, and demodulation circuitry to demodulate the amplified up-modulated sense capacitance signal based on the carrier signal, generating a demodulated sense capacitance signal. Data converter circuitry is useful to convert the demodulated sense capacitance signal to sensor digital data, such as one of (a) an analog-to-digital converter (ADC) coupled to an input filter, the input filter providing Nyquist filtering and carrier image rejection for the demodulated sense capacitance signal; or (b) a sigma delta converter that includes input Nyquist filtering and carrier image rejection. For wideband differential capacitive sensing: (a) the carrier/drive signal path circuitry generates first and second carrier/drive signals, that are integrated and driven out through first and second output nodes respectively to first and second sense capacitors; (b) in response to the first and second carrier drive signals, the first and second sense capacitors provide respective first and second up-modulated sense capacitance signals, corresponding to measured capacitance and up-modulated to the carrier frequency; and (c) the sense signal path circuitry receives at the input node the first and second up-modulated sense capacitance signals, which are summed into an up-modulated differential sense capacitance signal.

Design choices/modifications include: (a) including in the carrier/drive signal path, circuitry pre-scale circuitry to pre-scale the carrier/drive signal; (b) including in the sense signal path, EMI filter circuitry to EMI filter the up-modulated sense capacitance signal, and/or input bandpass filter circuitry to bandpass filter the up-modulated sense capacitance signal, and provide a bandpass-filtered sense capacitance signal to the amplifier circuitry; and (c) implementing amplification in the sense signal path with one of a charge amplifier including a feedback capacitor coupled to the amplifier inverting input, which is coupled to receive the up-modulated sense capacitance signal, and a transimpedance amplifier including a feedback resistor coupled to the amplifier inverting input, which is coupled to receive the up-modulated sense capacitance signal, with the carrier/drive signal path circuitry further including an integrator to integrate the carrier/drive signal.

Modifications are possible in the described embodiments, and other embodiments are possible, within the scope of the claims.

## Claims

1. A circuit suitable for capacitive sensing, comprising:
carrier generation circuitry (21) to generate a carrier signal at a carrier frequency;
reference circuitry (18) to generate a reference signal (31);
carrier/drive signal path circuitry to drive a carrier/drive signal (32) out through an output node (A), the carrier/drive signal (32) useable for capacitive sensing, including: modulation circuitry (23) to modulate the reference signal with the carrier signal to generate the carrier/drive signal (32) at the carrier frequency; and drive circuitry to drive the carrier/drive signal out through the output node (A); and
sense signal path circuitry to receive at an input node (B) an up-modulated sense capacitance signal corresponding to measured capacitance from capacitive sensing, wherein the sense capacitance signal is up-modulated to the carrier frequency based on the carrier/drive signal (32), including: amplifier circuitry (45) to generate an amplified up-modulated sense capacitance signal (48); and demodulation circuitry (24) to demodulate the amplified up-modulated sense capacitance signal (48) based on the carrier signal, generating a demodulated sense capacitance signal (49);
**characterised in that**
the amplifier circuitry (45) is a transimpedance amplifier including a feedback resistor coupled to the amplifier inverting input, which is coupled to receive the up-modulated sense capacitance signal, with the carrier/drive signal path circuitry further including an integrator to integrate the carrier/drive signal (32).

2. The circuit of claim 1, further comprising:
data conversion circuitry to convert the demodulated sense capacitance signal (49) to digital data, including: output filter circuitry to filter the demodulated sense capacitance signal (49), including Nyquist filtering and carrier image rejection; and analog-to-digital converter ADC (16) circuitry to digitize the demodulated sense capacitance signal (49), the ADC (16) referenced by reference signal; optionally wherein the data conversion circuitry includes a sigma delta converter that includes input filtering for Nyquist noise and carrier image rejection.

3. The circuit of claim 1, adapted for differential capacitive sensing with first and second sense capacitors, and wherein:
the carrier/drive signal path circuitry generates first and second carrier/drive signals, that are integrated and driven out through first and second output nodes (A1, A2) respectively to the first and second sense capacitors;
in response to the first and second carrier drive signals, the first and second sense capacitors provide respective first and second up-modulated sense capacitance signals, corresponding to measured capacitance and up-modulated to the carrier frequency; and
the sense signal path circuitry receives at the input node (B) the first and second up-modulated sense capacitance signals, which are summed into an up-modulated differential sense capacitance signal.

4. A system for capacitive sensing, comprising:
at least one sense capacitor;
a wideband capacitance to digital converter (WCDC) including at least one output node (A) coupled to a bottom terminal of the at least one sense capacitor, and an input node (B) coupled to a top terminal of the sense capacitor, including a circuit according to claim 1, the circuit further including:
data conversion circuitry to convert the demodulated sense capacitance signal (49) to sensor data corresponding to measured capacitance, the data converter referenced by the reference signal.

5. The system of claim 4, wherein the data converter circuitry is one of: an input filter coupled to an analog-to-digital converter ADC (16), the input filter providing Nyquist filtering and carrier image rejection for the demodulated sense capacitance signal (49); and a sigma delta converter that includes input Nyquist filtering and carrier image rejection.

6. The system of claim 1 or 4:
the carrier/drive signal path circuitry further including pre-scale circuitry to pre-scale the carrier/drive signal (32); and/or
the sense signal path circuitry further including: EMI filter circuitry to EMI filter the up-modulated sense capacitance signal; and/or input bandpass filter circuitry to bandpass filter the up-modulated sense capacitance signal, and to provide a bandpass-filtered sense capacitance signal to the amplifier circuitry (45).

7. The system of claim 1 or 4, wherein the carrier signal used to modulate the reference signal, and to demodulate the amplified up-modulated sense capacitance signal (48), is one of a fixed frequency signal and a spread spectrum signal.

8. The system of claim 4, further comprising first and second differential sense capacitors, wherein:
the WCDC includes first and second output nodes (A1, A2), and an input summing node;
the carrier/drive signal path circuitry generates first and second carrier/drive signals, that are integrated and driven out through the first and second output nodes (A1, A2) respectively to the first and second sense capacitors;
in response to the first and second carrier drive signals, the first and second sense capacitors provide respective first and second up-modulated sense capacitance signals, corresponding to measured capacitance and up-modulated to the carrier frequency; and
the sense signal path circuitry receives at the input summing node the first and second up-modulated sense capacitance signals, summed into an up-modulated differential sense capacitance signal.

9. A method for capacitive sensing adaptable to a capacitive sensing system that includes at least one sense capacitor, comprising:
generating a carrier signal at a carrier frequency;
generating a reference signal;
in a carrier/drive signal path, generating a carrier/drive signal for output to the at least one sense capacitor, including:
modulating the reference signal with the carrier signal to generate the carrier/drive signal (32) at the carrier frequency, and
driving the carrier/drive signal (32) out to the at least one sense capacitor to generate at least one up-modulated sense capacitance signal, corresponding to measured capacitance and up-modulated to the carrier frequency; and
in a sense signal path: receiving the sense capacitance signal corresponding to measured capacitance from the at least one sense capacitor, the sense capacitance signal up-modulated to the carrier frequency by the carrier/drive signal (32); amplifying the up-modulated sense capacitance signal; and demodulating the amplified up-modulated sense capacitance signal (48) using the carrier signal, generating a demodulated sense capacitance signal (49); and
converting the demodulated sense capacitance signal (49) to sensor data corresponding to the sense capacitance signal from the at least one sense capacitor;
**characterised in that**
amplification is accomplished by a transimpedance amplifier including a feedback resistor coupled to the amplifier inverting input, which is coupled to receive the up-modulated sense capacitance signal, with the carrier/drive signal path further including integrating the carrier/drive signal.

10. The method of claim 9, wherein converting the demodulated sense capacitance signal (49) to sensor data is accomplished by a sigma delta converter that includes input Nyquist filtering and carrier image rejection, the sigma delta converter referenced by the reference signal.

11. The method of claim 9, further comprising:
in the carrier/drive signal path, pre-scaling the carrier/drive signal; and/or
in the sense signal path: EMI filtering the up-modulated sense capacitance signal before amplification; and/or bandpass filtering the up-modulated sense capacitance signal before amplification.

12. The method of claim 9, wherein the carrier signal used to modulate the reference signal, and to demodulate the amplified up-modulated sense capacitance signal (48), is one of a fixed frequency signal and a spread spectrum signal.

13. The method of claim 9, adapted for use in a differential sensing system that includes first and second differential sense capacitors, further comprising:
in the carrier/drive signal path, generating first and second carrier/drive signals, driven out respectively to the first and second sense capacitors;
wherein, in response to the first and second carrier drive signals, the first and second sense capacitors provide respective first and second up-modulated sense capacitance signals, corresponding to measured capacitance and up-modulated to the carrier frequency; and
in the sense signal path, summing the first and second up-modulated sense capacitance signals as an up-modulated differential sense capacitance signal.

## Patentansprüche

1. Zur kapazitiven Erfassung geeignete Schaltung, die Folgendes umfasst:
eine Trägererzeugungsschaltungsanordnung (21) zum Erzeugen eines Trägersignals mit einer Trägerfrequenz;
eine Referenzschaltungsanordnung (18) zum Erzeugen eines Referenzsignals (31);
eine Träger-/Treibersignalpfad-Schaltungsanordnung zum Heraustreiben eines Träger-/Treibersignals (32) durch einen Ausgangsknoten (A), wobei das Träger-/Treibersignal (32) zur kapazitiven Erfassung verwendbar ist, umfassend: eine Modulationsschaltungsanordnung (23) zum Modulieren des Referenzsignals mit dem Trägersignal, um das Träger-/Treibersignal (32) mit der Trägerfrequenz zu erzeugen;
und eine Treiberschaltungsanordnung zum Heraustreiben des Träger-/Treibersignals durch den Ausgangsknoten (A); und
eine Erfassungssignalpfad-Schaltungsanordnung zum Empfangen, an einem Eingangsknoten (B), eines aufwärtsmodulierten Erfassungskapazitätssignals, das der gemessenen Kapazität aus der kapazitiven Erfassung entspricht, wobei das Erfassungskapazitätssignal basierend auf dem Träger-/Treibersignal (32) auf die Trägerfrequenz aufwärtsmoduliert ist, umfassend: eine Verstärkerschaltungsanordnung (45) zum Erzeugen eines verstärkten aufwärtsmodulierten Erfassungskapazitätssignals (48); und eine Demodulationsschaltungsanordnung (24) zum Demodulieren des verstärkten aufwärtsmodulierten Erfassungskapazitätssignals (48) basierend auf dem Trägersignal, wodurch ein demoduliertes Erfassungskapazitätssignal (49) erzeugt wird;
**dadurch gekennzeichnet, dass** es sich bei der Verstärkerschaltungsanordnung (45) um einen Transimpedanzverstärker einschließlich eines mit dem invertierenden Verstärkereingang gekoppelten Rückkopplungswiderstands handelt, der zum Empfangen des aufwärtsmodulierten Erfassungskapazitätssignals gekoppelt ist, wobei die Träger-/Treibersignalpfad-Schaltungsanordnung ferner einen Integrator zum Integrieren des Träger-/Treibersignals (32) umfasst.

2. Schaltung nach Anspruch 1, die ferner Folgendes umfasst: eine Datenumwandlungsschaltungsanordnung zum Umwandeln des demodulierten Erfassungskapazitätssignals (49) in digitale Daten, umfassend: eine Ausgangsfilterschaltungsanordnung zum Filtern des demodulierten Erfassungskapazitätssignals (49), einschließlich Nyquist-Filterung und Trägerspiegelunterdrückung; und eine Schaltungsanordnung eines Analog-Digital-Wandlers ADC (16) zum Digitalisieren des demodulierten Erfassungskapazitätssignals (49), wobei der ADC (16) durch das Referenzsignal referenziert wird; wobei optional die Datenumwandlungsschaltungsanordnung einen Sigma-Delta-Wandler umfasst, der Eingangsfilterung von Nyquist-Rauschen und Trägerspiegelunterdrückung umfasst.

3. Schaltung nach Anspruch 1, angepasst zur differenziellen kapazitiven Erfassung mit einem ersten und einem zweiten Erfassungskondensator, und wobei:
die Träger-/Treibersignalpfad-Schaltungsanordnung ein erstes und ein zweites Träger-/Treibersignal erzeugt, die integriert und durch einen ersten und einen zweiten Ausgangsknoten (A1, A2) an den ersten bzw. den zweiten Erfassungskondensator herausgetrieben werden;
der erste und der zweite Erfassungskondensator als Reaktion auf das erste und das zweite Träger-/Treibersignal ein jeweiliges erstes und zweites aufwärtsmoduliertes Erfassungskapazitätssignal bereitstellen, die der gemessenen Kapazität entsprechen und auf die Trägerfrequenz aufwärtsmoduliert sind; und
die Erfassungssignalpfad-Schaltungsanordnung am Eingangsknoten (B) das erste und das zweite aufwärtsmodulierte Erfassungskapazitätssignal empfängt, die in ein aufwärtsmoduliertes differenzielles Erfassungskapazitätssignal summiert sind.

4. System zur kapazitiven Erfassung, das Folgendes umfasst:
mindestens einen Erfassungskondensator;
einen Breitband-Kapazität-Digital-Wandler (WCDC), umfassend mindestens einen Ausgangsknoten (A), der mit einem unteren Anschluss des mindestens einen Erfassungskondensators gekoppelt ist, und einen Eingangsknoten (B), der mit einem oberen Anschluss des Erfassungskondensators gekoppelt ist, umfassend eine Schaltung nach Anspruch 1, wobei die Schaltung ferner Folgendes umfasst:
eine Datenumwandlungsschaltungsanordnung zum Umwandeln des demodulierten Erfassungskapazitätssignals (49) in Sensordaten, die der gemessenen Kapazität entsprechen, wobei der Datenwandler durch das Referenzsignal referenziert wird.

5. System nach Anspruch 4, wobei es sich bei der Datenwandlerschaltungsanordnung um eines der Folgenden handelt:
ein Eingangsfilter, das mit einem Analog-Digital-Wandler ADC (16) gekoppelt ist, wobei das Eingangsfilter Nyquist-Filterung und Trägerspiegelunterdrückung für das demodulierte Erfassungskapazitätssignal (49) bereitstellt; und einen Sigma-Delta-Wandler, der Eingangs-Nyquist-Filterung und Trägerspiegelunterdrückung umfasst.

6. System nach Anspruch 1 oder 4:
wobei die Träger-/Treibersignalpfad-Schaltungsanordnung ferner eine Vorskalierungsschaltungsanordnung zum Vorskalieren des Träger-/Treibersignals (32) umfasst; und/oder
die Erfassungssignalpfad-Schaltungsanordnung ferner Folgendes umfasst: eine EMI-Filter-Schaltungsanordnung zur EMI-Filterung des aufwärtsmodulierten Erfassungskapazitätssignals; und/oder eine Eingangsbandpassfilter-Schaltungsanordnung zur Bandpassfilterung des aufwärtsmodulierten Erfassungskapazitätssignals und zum Liefern eines bandpassgefilterten Erfassungskapazitätssignals an die Verstärkerschaltungsanordnung (45).

7. System nach Anspruch 1 oder 4, wobei es sich bei dem zum Modulieren des Referenzsignals und zum Demodulieren des verstärkten aufwärtsmodulierten Erfassungskapazitätssignals (48) verwendeten Trägersignal um ein Festfrequenzsignal oder ein Spreizspektrumsignal handelt.

8. System nach Anspruch 4, ferner umfassend einen ersten und einen zweiten differenziellen Erfassungskondensator, wobei:
der WCDC ein ersten und einen zweiten Ausgangsknoten (A1, A2) und einen Eingangssummierknoten umfasst;
die Träger-/Treibersignalpfad-Schaltungsanordnung ein erstes und ein zweites Träger-/Treibersignal erzeugt, die integriert und durch den ersten und den zweiten Ausgangsknoten (A1, A2) an den ersten bzw. den zweiten Erfassungskondensator herausgetrieben werden;
der erste und der zweite Erfassungskondensator als Reaktion auf das erste und das zweite Träger-/Treibersignal ein jeweiliges erstes und zweites aufwärtsmoduliertes Erfassungskapazitätssignal bereitstellen, die der gemessenen Kapazität entsprechen und auf die Trägerfrequenz aufwärtsmoduliert sind; und
die Erfassungssignalpfad-Schaltungsanordnung am Eingangssummierknoten das erste und das zweite aufwärtsmodulierte Erfassungskapazitätssignal empfängt, die in ein aufwärtsmoduliertes differenzielles Erfassungskapazitätssignal summiert sind.

9. Verfahren zur kapazitiven Erfassung, anpassbar an ein kapazitives Erfassungssystem, das mindestens einen Erfassungskondensator umfasst, umfassend:
Erzeugen eines Trägersignals mit einer Trägerfrequenz;
Erzeugen eines Referenzsignals;
in einem Träger-/Treibersignalpfad, Erzeugen eines Träger-/Treibersignals zur Ausgabe an den mindestens einen Erfassungskondensator, umfassend:
Modulieren des Referenzsignals mit dem Trägersignal, um das Träger-/Treibersignal (32) mit der Trägerfrequenz zu erzeugen, und
Heraustreiben des Träger-/Treibersignal (32) an den mindestens einen Erfassungskondensator, um mindestens ein aufwärtsmoduliertes Erfassungskapazitätssignal zu erzeugen, das der gemessenen Kapazität entspricht und auf die Trägerfrequenz aufwärtsmoduliert ist; und
in einem Erfassungssignalpfad: Empfangen des Erfassungskapazitätssignals, das der gemessenen Kapazität von dem mindestens einen Erfassungskondensator entspricht, wobei das Erfassungskapazitätssignal durch das Träger-/Treibersignal (32) auf die Trägerfrequenz aufwärtsmoduliert ist; Verstärken des aufwärtsmodulierten Erfassungskapazitätssignals; und
Demodulieren des verstärkten aufwärtsmodulierten Erfassungskapazitätssignals (48) unter Verwendung des Trägersignals, wodurch ein demoduliertes Erfassungskapazitätssignal (49) erzeugt wird; und
Umwandeln des demodulierten Erfassungskapazitätssignals (49) in Sensordaten, die Erfassungskapazitätssignal von dem mindestens einen Erfassungskondensator entsprechen;
**dadurch gekennzeichnet, dass** die Verstärkung durch einen Transimpedanzverstärker einschließlich eines mit dem invertierenden Verstärkereingang gekoppelten Rückkopplungswiderstands bewerkstelligt wird, der zum Empfangen des aufwärtsmodulierten Erfassungskapazitätssignals gekoppelt ist, wobei der Träger-/Treibersignalpfad ferner das Integrieren des Träger-/Treibersignals umfasst.

10. Verfahren nach Anspruch 9, wobei das Umwandeln des demodulierten Erfassungskapazitätssignals (49) in Sensordaten durch einen Sigma-Delta-Wandler bewerkstelligt wird, der Eingangs-Nyquist-Filterung und Trägerspiegelunterdrückung umfasst, wobei der Sigma-Delta-Wandler durch das Referenzsignal referenziert wird.

11. Verfahren nach Anspruch 9, das ferner Folgendes umfasst:
in dem Träger-/Treibersignalpfad, Vorskalieren des Träger-/Treibersignals; und/oder
in dem Erfassungssignalpfad: EMI-Filterung des aufwärtsmodulierten Erfassungskapazitätssignals vor der Verstärkung; und/oder Bandpassfilterung des aufwärtsmodulierten Erfassungskapazitätssignals vor der Verstärkung.

12. Verfahren nach Anspruch 9, wobei es sich bei dem zum Modulieren des Referenzsignals und zum Demodulieren des verstärkten aufwärtsmodulierten Erfassungskapazitätssignals (48) verwendeten Trägersignal um ein Festfrequenzsignal oder ein Spreizspektrumsignal handelt.

13. Verfahren nach Anspruch 9, angepasst zur Verwendung einen differenziellen Erfassungssystem, das einen ersten und einen zweiten differenziellen Erfassungskondensator umfasst, ferner umfassend:
in dem Träger-/Treibersignalpfad, Erzeugen eines ersten und eines zweiten Träger-/Treibersignals, die an den ersten bzw. den zweiten Erfassungskondensator herausgetrieben werden;
wobei der erste und der zweite Erfassungskondensator als Reaktion auf das erste und das zweite Träger-/Treibersignal ein jeweiliges erstes und zweites aufwärtsmoduliertes Erfassungskapazitätssignal bereitstellen, die der gemessenen Kapazität entsprechen und auf die Trägerfrequenz aufwärtsmoduliert sind; und
in dem Erfassungssignal, Summieren des ersten und des zweiten aufwärtsmodulierten Erfassungskapazitätssignals als aufwärtsmoduliertes differenzielles Erfassungskapazitätssignal.

## Revendications

1. Circuit adapté à une détection capacitive, comprenant :
des circuits de génération de porteur (21) pour générer un signal porteur à une fréquence porteuse ;
des circuits de référence (18) pour générer un signal de référence (31) ;
des circuits de chemin de signal porteur/d'attaque pour expulser un signal porteur/d'attaque (32) à travers un noeud de sortie (A), le signal porteur/d'attaque (32) étant utilisable pour une détection capacitive, comportant : des circuits de modulation (23) pour moduler le signal de référence avec le signal porteur afin de générer le signal porteur/d'attaque (32) à la fréquence porteuse ; et des circuits d'attaque pour expulser le signal porteur/d'attaque à travers le noeud de sortie (A) ; et
des circuits de chemin de signal de détection pour recevoir au niveau d'un noeud d'entrée (B) un signal de capacité de détection modulé vers le haut correspondant à une capacité mesurée provenant d'une détection capacitive, le signal de capacité de détection étant modulé vers le haut jusqu'à la fréquence porteuse sur la base du signal porteur/d'attaque (32), comportant : des circuits amplificateur (45) pour générer un signal de capacité de détection modulé vers le haut amplifié (48) ; et des circuits de démodulation (24) pour démoduler le signal de capacité de détection modulé vers le haut amplifié (48) sur la base du signal porteur, générant un signal de capacité de détection démodulé (49) ;
**caractérisé en ce que**
les circuits amplificateur (45) sont un amplificateur à transimpédance comportant une résistance de rétroaction couplée à l'entrée inverseuse d'amplificateur, qui est couplée pour recevoir le signal de capacité de détection modulé vers le haut,
avec les circuits de chemin de signal porteur/d'attaque comportant en outre un intégrateur pour intégrer le signal porteur/d'attaque (32).

2. Circuit selon la revendication 1, comprenant en outre : des circuits de conversion de données pour convertir le signal de capacité de détection démodulé (49) en données numériques, comportant : des circuits filtre de sortie pour filtrer le signal de capacité de détection démodulé (49), comportant un filtrage Nyquist et une réjection d'image de porteur ; et des circuits convertisseur analogique-numérique CAN (16) pour numériser le signal de capacité de détection démodulé (49), le CAN (16) étant référencé par le signal de référence ; éventuellement, les circuits de conversion de données comportant un convertisseur sigma-delta qui comporte un filtrage d'entrée pour un bruit de Nyquist et une réjection d'image de porteur.

3. Circuit selon la revendication 1, conçu pour une détection capacitive différentielle avec des premier et deuxième condensateurs de détection, et
les circuits de chemin de signal porteur/d'attaque générant des premier et deuxième signaux porteur/d'attaque, qui sont intégrés et expulsés à travers des premier et deuxième noeuds de sortie (A1, A2) respectivement vers les premier et deuxième condensateurs de détection ;
en réponse aux premier et deuxième signaux porteurs d'attaque, les premier et deuxième condensateurs de détection fournissant des premier et deuxième signaux de capacité de détection modulés vers le haut respectifs, correspondant à une capacité mesurée et modulés vers le haut jusqu'à la fréquence porteuse ; et
les circuits de chemin de signal de détection recevant au niveau du noeud d'entrée (B) les premier et deuxième signaux de capacité de détection modulés vers le haut, qui sont sommés en un signal de capacité de détection différentielle modulé vers le haut.

4. Système pour une détection capacitive, comprenant :
au moins un condensateur de détection ;
un convertisseur capacité-numérique à large bande (WCDC) comportant au moins un noeud de sortie (A) couplé à une borne inférieure de l'au moins un condensateur de détection, et un noeud d'entrée (B) couplé à une borne supérieure du condensateur de détection, comportant un circuit selon la revendication 1,
le circuit comportant en outre :
des circuits de conversion de données pour convertir le signal de capacité de détection démodulé (49) en données de capteur correspondant à une capacité mesurée, le convertisseur de données étant référencé par le signal de référence.

5. Système selon la revendication 4, les circuits convertisseur de données étant l'un parmi : un filtre d'entrée couplé à un convertisseur analogique-numérique CAN (16), le filtre d'entrée fournissant un filtrage Nyquist et une réjection d'image de porteur pour le signal de capacité de détection démodulé (49) ; et un convertisseur sigma-delta qui comporte un filtrage Nyquist et une réjection d'image de porteur d'entrée.

6. Système selon la revendication 1 ou 4 :
les circuits de chemin de signal porteur/d'attaque comportant en outre des circuits de pré-mise à l'échelle pour pré-mettre à l'échelle le signal porteur/d'attaque (32) ; et/ou les circuits de chemin de signal de détection comportant en outre : des circuits filtre EMI pour filtrer en EMI le signal de capacité de détection modulé vers le haut ; et/ou des circuits filtre passe-bande d'entrée pour filtrer en passe-bande le signal de capacité de détection modulé vers le haut, et pour fournir un signal de capacité de détection filtré en passe-bande aux circuits amplificateur (45).

7. Système selon la revendication 1 ou 4, le signal porteur utilisé pour moduler le signal de référence, et pour démoduler le signal de capacité de détection modulé vers le haut amplifié (48), étant l'un d'un signal à fréquence fixe et d'un signal à spectre étendu.

8. Système selon la revendication 4, comprenant en outre des premier et deuxième condensateurs de détection différentielle, le WCDC comportant des premier et deuxième noeuds de sortie (A1, A2), et un noeud de sommation d'entrée ;
les circuits de chemin de signal porteur/d'attaque générant des premier et deuxième signaux porteurs/d'attaque, qui sont intégrés et expulsés à travers les premier et deuxième noeuds de sortie (A1, A2) respectivement vers les premier et deuxième condensateurs de détection ;
en réponse aux premier et deuxième signaux porteurs d'attaque, les premier et deuxième condensateurs de détection fournissant des premier et deuxième signaux de capacité de détection modulés vers le haut respectifs, correspondant à une capacité mesurée et modulés vers le haut jusqu'à la fréquence porteuse ; et
les circuits de chemin de signal de détection recevant au niveau du noeud de sommation d'entrée les premier et deuxième signaux de capacité de détection modulés vers le haut, sommés en un signal de capacité de détection différentielle modulé vers le haut.

9. Procédé de détection capacitive adaptable à un système de détection capacitif qui comporte au moins un condensateur de détection, comprenant :
la génération d'un signal porteur à une fréquence porteuse ;
la génération d'un signal de référence ;
dans un chemin de signal porteur/d'attaque, la génération d'un signal porteur/d'attaque pour une délivrance à l'au moins un condensateur de détection, comportant :
la modulation du signal de référence avec le signal porteur pour générer le signal porteur/d'attaque (32) à la fréquence porteuse, et
l'expulsion du signal porteur/d'attaque (32) vers l'au moins un condensateur de détection pour générer au moins un signal de capacité de détection modulé vers le haut, correspondant à une capacité mesurée et modulé vers le haut jusqu'à la fréquence porteuse ; et
dans un chemin de signal de détection : la réception du signal de capacité de détection correspondant à la capacité mesurée en provenance de l'au moins un condensateur de détection, le signal de capacité de détection étant modulé vers le haut jusqu'à la fréquence porteuse par le signal porteur/d'attaque (32) ;
l'amplification du signal de capacité de détection modulé vers le haut ; et la démodulation du signal de capacité de détection modulé vers le haut amplifié (48) en utilisant le signal porteur, générant un signal de capacité de détection démodulé (49) ; et
la conversion du signal de capacité de détection démodulé (49) en données de capteur correspondant au signal de capacité de détection provenant de l'au moins un condensateur de détection ;
**caractérisé en ce que**
l'amplification est accomplie par un amplificateur à transimpédance comportant une résistance de rétroaction couplée à l'entrée inverseuse d'amplificateur, qui est couplée pour recevoir le signal de capacité de détection modulé vers le haut,
avec le chemin de signal porteur/d'attaque comportant en outre l'intégration du signal porteur/d'attaque.

10. Procédé selon la revendication 9, la conversion du signal de capacité de détection démodulé (49) en données de capteur étant accomplie par un convertisseur sigma-delta qui comporte un filtrage Nyquist et une réjection d'image de porteur d'entrée, le convertisseur sigma-delta étant référencé par le signal de référence.

11. Procédé selon la revendication 9, comprenant en outre :
dans le chemin de signal porteur/d'attaque, la pré-mise à l'échelle du signal porteur/d'attaque ; et/ou
dans le chemin de signal de détection : le filtrage EMI du signal de capacité de détection modulé vers le haut avant l'amplification ; et/ou le filtrage en passe-bande du signal de capacité de détection modulé vers le haut avant l'amplification.

12. Procédé selon la revendication 9, le signal porteur utilisé pour moduler le signal de référence, et pour démoduler le signal de capacité de détection modulé vers le haut amplifié (48), étant l'un d'un signal à fréquence fixe et d'un signal à spectre étalé.

13. Procédé selon la revendication 9, conçu pour une utilisation dans un système de détection différentielle qui comporte des premier et deuxième condensateurs de détection différentielle, comprenant en outre :
dans le chemin de signal porteur/d'attaque, la génération de premier et deuxième signaux porteurs/d'attaque, expulsés respectivement vers les premier et deuxième condensateurs de détection ;
en réponse aux premier et deuxième signaux porteurs d'attaque, les premier et deuxième condensateurs de détection fournissant des premier et deuxième signaux de capacité de détection modulés vers le haut respectifs, correspondant à une capacité mesurée et modulés vers le haut jusqu'à la fréquence porteuse ; et
dans le chemin de signal de détection, la sommation des premier et deuxième signaux de capacité de détection modulés vers le haut comme un signal de capacité de détection différentielle modulé vers le haut.
